# EUROPEAN PATENT SPECIFICATION

(11) **EP 4 425 251 B1**
(45) Date of publication and mention of the grant of the patent: **09.12.2026**
(21) Application number: 22885828.8
(22) Date of filing: 21.10.2022
(51) Int. Cl.: G02F 1/163, G01R 31/36

(54) **CALIBRATION METHOD AND APPARATUS FOR ELECTROCHROMIC DEVICE, AND ELECTROCHROMIC DEVICE**
KALIBRIERUNGSVERFAHREN UND -VORRICHTUNG FÜR ELEKTROCHROME VORRICHTUNG UND ELEKTROCHROME VORRICHTUNG
PROCÉDÉ ET APPAREIL D'ÉTALONNAGE POUR DISPOSITIF ÉLECTROCHROMIQUE, ET DISPOSITIF ÉLECTROCHROMIQUE

(30) Priority: 28.10.2021 CN 202111260799
(43) Date of publication of application: 04.09.2024
(73) Proprietor: Guangyi Intelligent Tech (Suzhou) Co., Ltd., Suzhou, Jiangsu 215000 (CN)
(72) Inventor: XU, Zhixiang, Suzhou, Jiangsu 215000 (CN)
(74) Representative: Wallinger Ricker Schlotter PartGmbB
(86) International application number: PCT/CN2022/126840
(87) International publication number: WO 2023/071951

(56) References cited:
- CN-A- 108 780 260
- CN-A- 112 817 193
- CN-A- 113 156 730
- CN-A- 114 839 819
- CN-A- 115 157 978
- US-A- 5 822 107
- US-A1- 2014 268 285
- US-A1- 2020 061 975
- US-A1- 2021 231 981

## Description

### TECHNICAL FIELD

The present application relates to the field of electrochromic technology, in particular, a calibration method and apparatus for an electrochromic device, and an electrochromic device.

### BACKGROUND

In existing art, an electrochromic device is generally divided into different gears according to transmittances, then a series of open circuit voltages (that is, OCV) corresponding to the gears are obtained via test experiments, and then gear shift of the device is controlled according to the OCV. In practical use, it has been found that light transmittance may have better accuracy when the device is in the early stage of use or when the environment is suitable. However, with the constant aging of the electrochromic device or a great change in the ambient temperature, the corresponding relationship between the OCV and the transmittances of the electrochromic device changes, leading to the inability to accurately adjust the transmittances of the device according to the pre-stored OCV relationship and affecting users' use. CN 113 156 730 A is a background art document useful for understanding the invention.

### SUMMARY

Embodiments of the present application provide a calibration method and apparatus for an electrochromic device, and an electrochromic device. The method can achieve an accurate adjustment of the electrochromic device in different state environments via self-calibration control and can also avoid overcharge and over-discharge of the device which affect the performance of the device.

In a first aspect, embodiments of the present application provide a calibration method for an electrochromic device. The calibration method may include:
determining a current total capacity of the electrochromic device after a self-calibration mode is entered;
in response to a difference between a total capacity of the electrochromic device determined last time and the current total capacity of the electrochromic device exceeding a preset error range, setting the current total capacity as a latest total capacity, and according to the current total capacity and based on a predetermined capacity distribution ratio, re-determining a corresponding relationship between each current gear of the electrochromic device and a capacity of the electrochromic device;
charging the electrochromic device with a charge capacity of a preset distribution ratio each time according to a preset number of charging times, waiting for a preset period after charging, and measuring and recording a current open circuit voltage of the electrochromic device after each charge to obtain a plurality of sets of measurement data of a current capacity and a corresponding open circuit voltage of the electrochromic device;
fitting the plurality of sets of measurement data to obtain a functional relationship between capacities and open circuit voltages;
re-determining a relationship among the each current gear of the electrochromic device, the capacity of the electrochromic device, and an open circuit voltage of the electrochromic device according to the current total capacity and the functional relationship and based on the predetermined capacity distribution ratio;
each time a number of operations of re-determining the corresponding relationship between the each current gear of the electrochromic device and the capacity of the electrochromic device according to the current total capacity and based on the predetermined capacity distribution ratio is greater than or equal to a preset number of calibration switching times, performing a calibration after the self-calibration mode is entered next time and in a manner of re-determining the relationship among the each current gear of the electrochromic device, the capacity of the electrochromic device, and the open circuit voltage of the electrochromic device according to the current total capacity and the functional relationship and based on the predetermined capacity distribution ratio.

The electrochromic device is triggered to enter the self-calibration mode when any one or a combination of the following triggering conditions is satisfied: when a total number of gear shifts reaches a preset number threshold; when a time interval from a last calibration reaches a preset time threshold; when a use time of the electrochromic device reaches a preset use time threshold; when a current gear shift operation is not completed when a maximum gear shift duration is exceeded; and when a difference between an open circuit voltage after completion of a current gear shift and an open circuit voltage corresponding to a target gear is not within a preset voltage difference range.

Optionally, determining the current total capacity of the electrochromic device may include:
discharging the electrochromic device until a full discharge state is reached, charging the electrochromic device until a full charge state is reached, and recording a full charge capacity required by the electrochromic device from the full discharge state to the full charge state, where the full charge capacity is used as the current total capacity of the electrochromic device; or
charging the electrochromic device until a full charge state is reached, discharging the electrochromic device until a full discharge state is reached, and recording a full discharge capacity required by the electrochromic device from the full charge state to the full discharge state, where the full discharge capacity is used as the current total capacity of the electrochromic device.

Optionally, before determining the current total capacity of the electrochromic device, the calibration method may further include:
according to a smaller value of the full charge capacity and the full discharge capacity obtained from an initial test of the electrochromic device, using a full charge test process or a full discharge test process corresponding to the smaller value as a test process for subsequently determining the current total capacity of the electrochromic device.

Optionally, the predetermined capacity distribution ratio and an initial corresponding relationship between each gear and the capacity of the electrochromic device may be obtained in advance in the following manners:
charging and discharging the electrochromic device, and measuring corresponding open circuit voltages and capacities of the electrochromic device at different transmittances to obtain an initial corresponding relationship among the each gear of the electrochromic device, an open circuit voltage of the electrochromic device, and the capacity of the electrochromic device, where different transmittances correspond to different gears; and
obtaining a capacity distribution ratio corresponding to the each gear of the electrochromic device according to a ratio of a capacity corresponding to the each gear of the electrochromic device to a total capacity of the electrochromic device at a corresponding measurement stage.

Optionally, the predetermined capacity distribution ratio and an initial corresponding relationship between each gear and the capacity of the electrochromic device may also be obtained in advance in the following manners:
performing capacity distribution on the each gear according to a number of gears of the electrochromic device and based on a set capacity distribution ratio to obtain a capacity corresponding to the each gear; and
charging and discharging the electrochromic device, monitoring current capacities of the electrochromic device, and in response to the monitored current capacities being separately equal to distributed capacities, recording corresponding open circuit voltages to obtain an initial corresponding relationship among the each gear of the electrochromic device, an open circuit voltage of the electrochromic device, and the capacity of the electrochromic device.

Optionally, the predetermined capacity distribution ratio and an initial corresponding relationship between each gear and the capacity of the electrochromic device may also be obtained in advance in the following manners:
performing capacity distribution on the each gear according to a number of gears of the electrochromic device and based on a set capacity distribution ratio to obtain a capacity corresponding to the each gear; and
selecting capacities corresponding to part gears for testing, and according to a test result, obtaining an initial corresponding relationship among the each gear of the electrochromic device, an open circuit voltage of the electrochromic device, and a capacity of the electrochromic device by function fitting.

Optionally, the calibration method may further include: after the latest total capacity is determined, updating the corresponding relationship between the each gear of the electrochromic device and the capacity of the electrochromic device for a subsequent gear shift operation.

Optionally, the electrochromic device may store a plurality of temperature ranges for dividing temperature values, the plurality of temperature ranges comprise an extreme temperature range, a normal temperature range, and an intermediate temperature range other than the normal temperature range and the extreme temperature range, and after the self-calibration mode is entered, the method may further include:
determining a temperature range in which a current ambient temperature of the electrochromic device is located;
in a case where the temperature range in which the current ambient temperature of the electrochromic device is located is in the extreme temperature range, stopping a current self-calibration operation;
in a case where the temperature range in which the current ambient temperature of the electrochromic device is located is in the normal temperature range, performing a step of determining the current total capacity of the electrochromic device;
in a case where the temperature range in which the current ambient temperature of the electrochromic device is located is in the intermediate temperature range, adjusting the determined current total capacity according to a preset temperature coefficient after the current total capacity of the electrochromic device is determined.

In a second aspect, embodiments of the present application provide a method for controlling an electrochromic device. The control method may include:
detecting whether a gear shift signal exists after self-calibration is performed using the calibration method of the calibration method;
identifying a current gear and acquiring a target gear from the gear shift signal upon receiving a gear shift signal;
calculating a capacity difference between the target gear and the current gear according to a latest determined corresponding relationship between each gear and a capacity of the electrochromic device; and
charging or discharging the electrochromic device according to the capacity difference to switch the electrochromic device to the target gear.

In a third aspect, embodiments of the present application provide a calibration apparatus for an electrochromic device. The calibration apparatus may include:
a determination module, may be configured to determine a current total capacity of the electrochromic device after a self-calibration mode is entered.
an adjustment module, may be configured to set the current total capacity as a latest total capacity in response to a difference between a total capacity of the electrochromic device determined last time and the current total capacity of the electrochromic device exceeding a preset error range, and re-determine a corresponding relationship between each current gear of the electrochromic device and a capacity of the electrochromic device according to the current total capacity and based on a predetermined capacity distribution ratio.

The calibration apparatus may further include:
an acquisition module, may be configured to charge the electrochromic device with a charge capacity of a preset distribution ratio each time according to the preset number of charging times, wait for a preset period after charging, and measure and record a current open circuit voltage of the electrochromic device after each charge to obtain a plurality of sets of measurement data of a current capacity and a corresponding open circuit voltage of the electrochromic device;
a fitting module, may be configured to fit the plurality of sets of measurement data to obtain a functional relationship between capacities and open circuit voltages; where the adjustment module is further configured to re-determine a relationship among the each current gear of the electrochromic device, the capacity of the electrochromic device, and an open circuit voltage of the electrochromic device according to the current total capacity and the functional relationship and based on the predetermined capacity distribution ratio;
a switch module, may be configured to, in response to a number of operations performed by the adjustment module to re-determine the corresponding relationship between the each current gear of the electrochromic device and the capacity of the electrochromic device according to the current total capacity and based on the predetermined capacity distribution ratio being greater than or equal to a preset number of calibration switching times, switch to perform a calibration after the self-calibration mode is entered next time and in a manner of re-determining the relationship among the each current gear of the electrochromic device, the capacity of the electrochromic device, and the open circuit voltage of the electrochromic device according to the current total capacity and the functional relationship and based on the predetermined capacity distribution ratio; and
a measurement module, may be configured to charge and discharge the electrochromic device, and measure corresponding open circuit voltages and capacities of the electrochromic device at different transmittances to obtain an initial corresponding relationship among the each gear of the electrochromic device, an open circuit voltage of the electrochromic device, and the capacity of the electrochromic device; and obtain a capacity distribution ratio corresponding to the each gear of the electrochromic device according to a ratio of a capacity corresponding to the each gear of the electrochromic device to a total capacity of the electrochromic device at a corresponding measurement stage.

In an embodiment, the measurement module may be configured to may be configured to perform capacity distribution on the each gear according to a number of gears of the electrochromic device and based on a set capacity distribution ratio to obtain a capacity corresponding to the each gear; and charge and discharge the electrochromic device, monitor current capacities of the electrochromic device, and in response to the monitored current capacities being separately equal to distributed capacities, record a corresponding open circuit voltages to obtain an initial corresponding relationship among the each gear of the electrochromic device, an open circuit voltage of the electrochromic device, and the capacity of the electrochromic device.

The determination module may include:
a charge-discharge control sub-module, may be configured to, in response to the current total capacity of the electrochromic device being determined, discharge the electrochromic device until a full discharge state is reached, and charge the electrochromic device until a full charge state is reached. Alternatively, a charge-discharge control sub-module, may be configured to, in response to the current total capacity of the electrochromic device being determined, charge the electrochromic device until a full charge state is reached, and discharge the electrochromic device until a full discharge state is reached;
a recording sub-module, may be configured to record a full charge capacity required by the electrochromic device from the full discharge state to the full charge state, where the full charge capacity is used as the current total capacity of the electrochromic device. Alternatively, a recording sub-module, may be configured to record a full discharge capacity required by the electrochromic device from the full charge state to the full discharge state, where the full discharge capacity is used as the current total capacity of the electrochromic device.

In a fourth aspect, embodiments of the present application provide an electrochromic device. The electrochromic device may include a processor and a memory, where the memory stores a computer program, and the processor is configured to execute the computer program to implement the calibration or the control method described above.

In a fifth aspect, embodiments of the present application provide a readable storage medium storing a computer program which, when executed by a processor, implements the calibration or control method described above.

Embodiments of the present application may have the following beneficial effects:

In the calibration method for an electrochromic device according to embodiments of the present application, a self-calibration mode is entered when a triggering condition is satisfied, the current total capacity of the electrochromic device is determined, and the total capacity is updated when a large deviation exists between the current total capacity and the total capacity stored last time. Meanwhile, the corresponding relationship between each gear and the capacity is re-determined in combination with a predetermined capacity distribution ratio for subsequent gear shifts. The method can achieve an accurate adjustment of the electrochromic device in different state environments, improve the user experience, and can also avoid overcharge and over-discharge of the device which affect the performance of the device.

### BRIEF DESCRIPTION OF DRAWINGS

To illustrate the technical solutions in embodiments of the present application more clearly, the drawings used in the embodiments are described briefly below. It is to be understood that the following drawings illustrate only certain embodiments of the present application and are therefore not to be construed as limiting the scope. Those of ordinary skill in the art may acquire other related drawings based on these drawings on the premise that no creative work is done.
FIG. 1 shows a first flowchart of a calibration method for an electrochromic device according to some embodiments of the present application.
FIG. 2 shows a first flowchart of a calibration method for an electrochromic device according to some other embodiments of the present application.
FIG. 3 shows a second flowchart of a calibration method for an electrochromic device according to some other embodiments of the present application.
FIG. 4 shows a first flowchart of a calibration method for an electrochromic device according to some other embodiments of the present application.
FIG. 5 shows a second flowchart of a calibration method for an electrochromic device according to some other embodiments of the present application.
FIG. 6 shows a flowchart of a control method for an electrochromic device according to some other embodiments of the present application.
FIG. 7 shows a diagram illustrating the structure of a calibration apparatus for an electrochromic device according to some other embodiments of the present application.

### DETAILED DESCRIPTION

The technical solutions in embodiments of the present application are described clearly and completely in conjunction with the drawings in embodiments of the present application. Apparently, the embodiments described below are part, not all, of the embodiments of the present application.

The assemblies of embodiments of the present application described and illustrated in the drawings herein may generally be arranged and designed in various different configurations. Therefore, the following detailed description of embodiments of the present application shown in the drawings is not intended to limit the scope of the present application, but merely illustrates the selected embodiments of the present application. Based on the embodiments of the present application, all other embodiments acquired by those skilled in the art are within the scope of the present application on the premise that no creative work is done.

Hereinafter, terms "including", "having", and cognates thereof that may be used in various embodiments of the present application are only intended to represent specific features, numbers, steps, operations, elements, components, or combinations thereof, and it should not be understood that the existence of one or more other features, numbers, steps, operations, elements, components, or combinations thereof is first excluded or that the possibilities of adding one or more features, numbers, steps, operations, elements, components, or combinations thereof are excluded.

Moreover, terms such as "first", "second", and "third" are merely for distinguishing the description and are not to be construed as indicating or implying relative importance.

Unless otherwise specified, all terms (including technical terms and scientific terms) used herein have the same meaning as commonly understood by those of ordinary skill in the art to which various embodiments of the application belong. The terms, such as those defined in commonly used dictionaries, are interpreted as having the same meaning as the contextual meaning in the relevant technical field and are not interpreted as having an idealized meaning or an overly formal meaning, unless clearly defined in the various embodiments of the present application.

In the existing art, the gear shift and control is usually performed according to the OCV value corresponding to each gear of an electrochromic device. However, when the device is aging, the corresponding relationship between the OCV and the transmittance or gear changes of the device. For example, Table 1 below shows the corresponding relationships among the transmittances, OCV, and gears of an electrochromic device tested before and after aging.

**Table 1**

| Gear | 1 | 2 | 3 | 4 | 5 |
|---|---|---|---|---|---|
| Transmittance | 1% | 5% | 10% | 20% | 40% |
| OCV (before aging) | -0.7V | -0.5V | 0 | 0.5V | 0.7V |
| OCV (after aging) | unreachable | -0.7V | 0 | 0.7V | 0.9V |

It can be seen from Table 1 that if a user wants to switch to the second gear before the aging of the device, it is necessary to control the OCV to reach -0.5 V; however, after the aging of the device, if the OCV is controlled to reach -0.5 V, the device cannot reach the second gear, and -0.7 V needs to be reached to switch to the second gear. It can be explained that when the corresponding relationship between the OCV and the transmittance of the device changes, accurate gear shifts and adjustments cannot be achieved for the device only according to the preceding fixedly stored relationships between the gears and the OCV. In fact, the preceding gear shift mode may also lead to accelerated failure of the device, reduced service life of the device, and other problems. For example, if a user wants to switch to the first gear, it is necessary to control the OCV to reach -0.7 V. In this case, the device is always charged and discharged by the power supply until the gear is reached. However, due to aging, the device cannot reach -0.7 V. Therefore, the device is still charged and discharged, and such a long-time overcharge and over-discharge may cause irreversible damage to the device.

To solve the preceding problems, an embodiment of the present application provides a calibration method for an electrochromic device. In practical use, the corresponding relationship among each gear, the corresponding capacity and OCV of an electrochromic device may be continuously updated by regular or irregular self-calibration of the device to obtain the latest state of the electrochromic device. The gear shift control is achieved by using the newly updated preceding corresponding relationship so that the accurate color change adjustment of the device can be achieved in different states, and the service life can be improved as much as possible on the premise of meeting user needs. The following description is made in connection with specific embodiments.

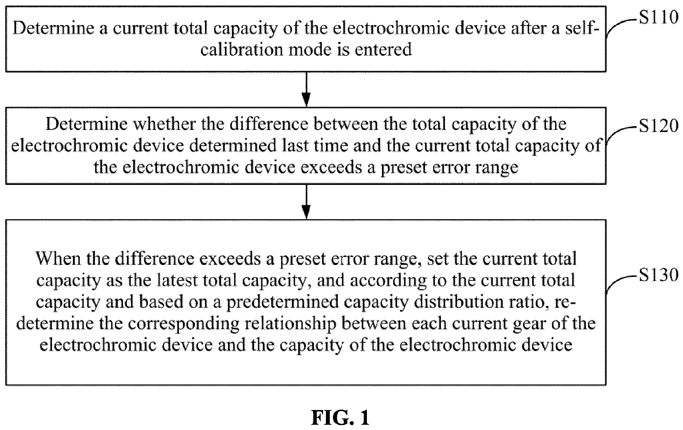

A detailed description of some embodiments of the present application is given below with reference to the accompanying drawings. FIG. 1 shows a first flowchart of a calibration method for an electrochromic device according to an embodiment of the present application. Exemplarily, the calibration method for an electrochromic device includes S110 to S130.

S110: A current total capacity of the electrochromic device is determined after a self-calibration mode is entered.

The self-calibration mode refers to a state mode where the electrochromic device performs the self-calibration. In this state mode, the electrochromic device stops shifting gears and performs calibration-related operations, and allows a gear shift operation only after the calibration operations are completed. For example, when it is detected that certain triggering conditions are satisfied, the process of self-calibration is started, and at this time it can be considered that the preceding self-calibration mode is entered.

Optionally, the electrochromic device may be triggered to enter the self-calibration mode when any of the following triggering conditions is satisfied. For example, triggering conditions for entering the self-calibration mode may include, but are not limited to one or more combinations of the following: when the total number of gear shifts accumulated by the device reaches a preset number threshold; when the time interval from the last calibration reaches a preset time threshold; and when the use time of the device reaches a preset use time threshold.

The triggering conditions enumerated above may be divided into determinate triggering conditions. Additionally, the triggering condition may also include indeterminate triggering conditions. For example, an entry into the self-calibration mode may also be triggered when an abnormality occurs in the gear shift operation. For example, the indeterminate triggering conditions also include, but are not limited to one or a combination of the following: when the current gear shift operation is not completed when the maximum gear shift duration is exceeded, that is, a gear shift timeout occurs; when the difference between an open circuit voltage after completion of the current gear shift and an open circuit voltage corresponding to the target gear is not within a preset voltage difference range.

As the device is continuously used, the total capacity of the electrochromic device varies with the state of the material due to the characteristics of the electrochromic material. In this embodiment, the gear shift operation is completed mainly based on the capacity, and the OCV corresponding to each gear may also be used to verify the accuracy after the gear shift. Moreover, when self-calibration is required, the current total capacity of the electrochromic device is re-determined, and then the total capacity is used for updating the corresponding relationship between each gear and the capacity of the electrochromic device.

Generally, two states exist in the electrochromic device, that is, a full charge state when the device is fully charged and a full discharge state when the device is fully discharged. The charge capacity required from the full discharge state to the full charge state is defined as a full charge capacity Q1. The charge capacity required from the full charge state to the full discharge state is defined as a full discharge capacity Q2. When the device is about to reach the full charge state or full discharge state, the charge or discharge current gradually tends to be zero. Since it takes a long time to reach the completely zero current, a cutoff current close to zero is configured in this embodiment to reduce the waiting time of users. When it is detected that the charge or discharge current is less than or equal to the cutoff current, it can be considered that the device reaches the full charge state or the full discharge state.

For S110 where the current total capacity of the electrochromic device is determined, in an embodiment, the current device may be discharged and the discharge current is detected in real time until the discharge current is less than or equal to a preset cutoff current, that is, after the full discharge state is reached, the device is charged until the charge current is less than or equal to the preset cutoff current, that is, when the full charge state is reached, and the full charge capacity Q1 required by the device from being fully discharged to being fully charged is recorded. At this time, the fully charge capacity is used as the current total capacity of the device.

Similarly, in another embodiment, the full discharge capacity Q2 required from the full charge state to the full discharge state may be used as the current total capacity of the electrochromic device. Exemplarily, the current device may be charged first and the charge current is detected in real time until the charge current is less than or equal to the preset cutoff current, that is, when the full charge state is reached, charging is stopped and the device is discharged until the discharge current is less than or equal to the present cutoff current, that is, when the full discharge state is reached, and the full discharge capacity Q2 required by the device from being fully charged to being fully discharged is recorded. At this time, the full discharge capacity is used as the current total capacity of the device.

Optionally, for example, when the original total capacity of the device is measured before leaving the factory, the full charge capacity Q1 and the full discharge capacity Q2 of the device are first measured, and the smaller value of the two is used as the original total capacity of the device. Meanwhile, the full charge test process or the full discharge test process corresponding to the smaller value is used as the test process for subsequently determining the current total capacity of the electrochromic device. For example, when the full charge capacity is used as the total capacity, the current full charge capacity is determined according to the test process of fully discharging first and then fully charging when self-calibration is performed subsequently.

It can be understood that in the charging and discharging process of the electrochromic material, the reversibility of the electrochromic material affects the relationship between the full charge capacity Q1 and the full discharge capacity Q2 so that the full charge capacity Q1 is not necessarily the same as the full discharge capacity Q2. The better the reversibility is, the closer Q1 and Q2 are; the worse the reversibility is, the greater the difference between Q1 and Q2 is. If the greater value of Q1 and Q2 is used as the total capacity of the device, overcharge or over-discharge of the device may be caused, affecting the performance of the device. Therefore, the smaller value of the two is defined herein as the total capacity.

S120: It is determined whether the difference between a total capacity of the electrochromic device determined last time and the current total capacity of the electrochromic device exceeds a preset error range.

Exemplarily, after the current total capacity is acquired by using S110, it may be determined whether the absolute value of the difference between the total capacity determined last time and the current total capacity is greater than or equal to a preset ratio of the total capacity determined last time, such as 0.3% to 0.6%, etc., which may be adjusted adaptively according to actual needs. If the absolute value is greater than or equal to the preset ratio, it indicates that the current state of the device may have changed to some extent from before. Therefore, S130 may be performed to ensure the accuracy of subsequent gear shifts and adjustments.

Optionally, if the difference is within the preset error range, the total capacity determined last time may be maintained, that is, the value of the total capacity is not updated, and in this case, the self-calibration mode may be exited and a shift signal is waited for. It can be understood that the preceding total capacity determined last time may refer to the original total capacity obtained by testing of the device at the time of leaving the factory or may refer to the latest total capacity re-determined after the device performs a corresponding self-calibration.

S130: When the difference exceeds a preset error range, the current total capacity is set as the latest total capacity, and according to the current total capacity and based on a predetermined capacity distribution ratio, the corresponding relationship between each current gear of the electrochromic device and the capacity of the electrochromic device is re-determined.

The preceding predetermined capacity distribution ratio refers to the ratio of the capacity corresponding to each gear to the total capacity, which may be obtained by debugging before leaving the factory. In subsequent operations, the distribution ratio continues to be used, and the corresponding relationship between each gear and the capacity is updated only by updating the value of the total capacity during self-calibration. It can be understood that the device in this embodiment stores the preceding capacity distribution ratio information and the initial corresponding relationship among each gear, the open circuit voltage, and the capacity of the device before leaving the factory for performing subsequent gear shift and control.

In an embodiment, the predetermined capacity distribution ratio and the initial corresponding relationship between each gear of the electrochromic device and the capacity of the electrochromic device may be obtained in the manner where the capacity and OCV corresponding to each gear are determined first, and then the capacity distribution ratio is determined. The specific manner is as follows:
(1) The electrochromic device is charged and discharged, and corresponding open circuit voltages and capacities of the electrochromic device are measured at different transmittances to obtain the initial corresponding relationship among each gear of the electrochromic device, the open circuit voltage of the electrochromic device, and the capacity of the electrochromic device. Different transmittances correspond to different gears.
(2) The capacity distribution ratio corresponding to each gear of the electrochromic device may be obtained according to the ratio of the measured capacity corresponding to each gear to the total capacity of the electrochromic device at the corresponding measurement stage which is usually the ratio of the capacity corresponding to each gear to the original total capacity at the time of leaving the factory. For example, the initial corresponding relationship among six gears of an electrochromic device, the OCV of the electrochromic device, and the capacity of the electrochromic device is described in Table 2 below.

**Table 2**

| Gear | 1 | 2 | 3 | 4 | 5 | 6 |
|---|---|---|---|---|---|---|
| Transmittance | 1% | 5% | 10% | 20% | 40% | 60% |
| OCV | -0.7V | -0.5V | 0 | 0.5V | 0.7V | 0.9V |
| Capacity | 0 | 0.05Q | 0.2Q | 0.35Q | 0.65Q | Q |

Additionally, in another embodiment, the predetermined capacity distribution ratio and the initial corresponding relationship between each gear of the electrochromic device and the capacity of the electrochromic device may also be obtained in the manner where the capacity distribution ratio is determined first, and then the capacity and OCV corresponding to each gear are determined. The specific manner is as follows:
(1) Capacity distribution is performed on each gear according to the number of gears of the electrochromic device and based on a set capacity distribution ratio to obtain the capacity corresponding to each gear.
(2) The device is charged and discharged, the current capacities of the device are monitored, and when the monitored current capacities are separately equal to distributed capacities, the corresponding OCV are recorded to obtain the initial corresponding relationship among each gear of the device, the OCV of the device, and the capacity of the device.

Of course, for the preceding embodiment, function fitting may be used for determining the initial corresponding relationship among each gear, the open circuit voltage, and the capacity. For example, capacities corresponding to part gears may be selected for testing such as at least four gears so that it is not necessary to test all the gears. In this manner, when many gears are provided, the workload of detection and the error in gear measurement can be greatly reduced.

For S130, exemplarily, after the new total capacity is determined, the current corresponding relationship between each gear of the electrochromic device and the capacity of the electrochromic device is updated. For example, the corresponding relationship stored in Table 2 is used as an example. The total capacity Q in Table 2 may be updated to Q', and at this time, the capacity value corresponding to each gear changes, and a new corresponding relationship between each gear and the capacity is able to be obtained.

When a gear shift signal is received, the subsequent gear shift operation may be performed using the updated corresponding relationship. For example, the current gear of the device may be identified according to the current OCV, and then charge or discharge is controlled according to the capacity difference between the current gear and the target gear to switch to the target gear.

It should be noted that in this embodiment, only the capacity is updated, and the gear may be identified in conjunction with the corresponding relationship stored last time between each gear and the OCV. It can be understood that when the device is in the initial and intermediate stages of use, the range of variation of the OCV corresponding to each gear is generally not too large. It has been verified by testing that the OVC generally changes within the allowable deviation range of the OCV corresponding to each gear, so the OCV may not be updated during this period.

In the calibration method for an electrochromic device according to this embodiment, a self-calibration mode is entered when a triggering condition is satisfied, the current total capacity of the electrochromic device is determined, and the total capacity is updated when a large deviation exists between the current total capacity and the total capacity stored last time. Meanwhile, the corresponding relationship between each gear and the capacity is re-determined in combination with a predetermined capacity distribution ratio for subsequent gear shifts. The method can achieve an accurate adjustment of the electrochromic device in different state environments, improve the user experience, and avoid overcharge and over-discharge of the device which affect the performance of the device.

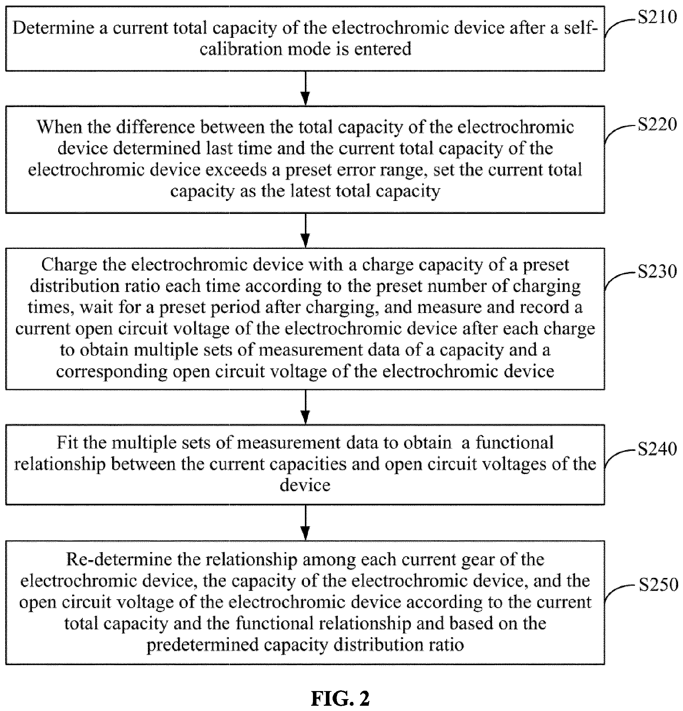

A detailed description of some other embodiments of the present application is given below with reference to the accompanying drawings. With reference to FIG. 2, this embodiment proposes a calibration method for an electrochromic device. This method differs from the method of the embodiment described above in that the current corresponding relationship among each gear, the capacity, and the OCV of the electrochromic device is re-determined in this embodiment, that is, the capacity and OCV corresponding to each gear are updated at the same time.

Exemplarily, the calibration method for an electrochromic device includes the steps described below.

S210: A current total capacity of the electrochromic device is determined after a self-calibration mode is entered.

S220: When the difference between the total capacity of the electrochromic device determined last time and the current total capacity of the electrochromic device exceeds a preset error range, the current total capacity is set as the latest total capacity.

S210 and S220 may refer to S110 and S120 described above, and the description is not repeated herein.

S230: The electrochromic device is charged with a charge capacity of a preset distribution ratio each time according to the preset number of charging times, a preset period is waited for after charging, and a current open circuit voltage of the electrochromic device is measured and recorded after each charge to obtain multiple sets of measurement data of a capacity and a corresponding open circuit voltage of the electrochromic device.

Since the function between the capacity and the OCV of the device is mainly a cubic function, the preset number of charging times in this embodiment should be greater than or equal to 3, which, together with one measurement before the capacity is charged, it is ensured that at least four sets of measurement data are obtained, satisfying the data requirement of function fitting.

The preset distribution ratio may be configured according to the preset number of charging times. For example, the preset number of charging times is used as an example. When the number of charging times is 3, the device may be charged with a capacity of Q/3 each time. Additionally, configuration may be made according to the capacity distribution ratio corresponding to each gear. For example, when the number of gears is 5, and the capacity ratio of the gears is evenly distributed, the device may be charged 4 times with a capacity of Q/4 each charge. In this manner, five sets of measurement data including capacities and corresponding open circuit voltages of different gears are obtained.

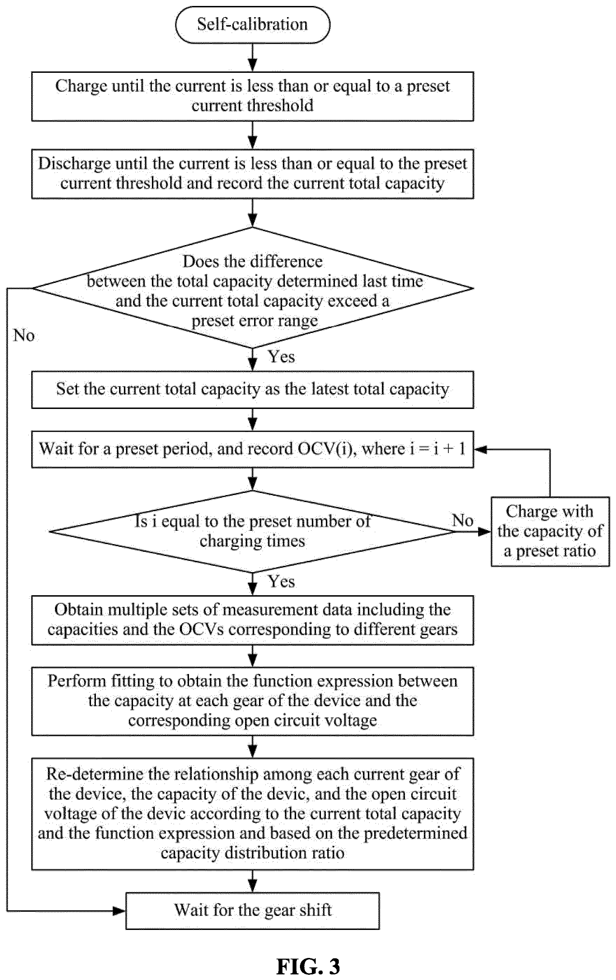

Exemplarily, as shown in FIG. 3, after the latest total capacity is determined, the current open circuit voltage may be measured after a preset period and denoted as OCV (0), and then one is added to i; then the device is charged once according to the corresponding distribution ratio, and after another preset period, the open circuit voltage after the current charge is read and denoted as OCV (1); such a step is repeated until i is equal to the preset number of charging times; multiple sets of measurement data are obtained by recording the open circuit voltage after the corresponding capacity is charged each time.

S240: The multiple sets of measurement data are fitted to obtain a functional relationship between the current capacities and open circuit voltages of the device.

S250: The relationship among each current gear of the electrochromic device, the capacity of the electrochromic device, and the open circuit voltage of the electrochromic device is re-determined according to the current total capacity and the functional relationship and based on the predetermined capacity distribution ratio.

Exemplarily, the multiple sets of measurement data may be fitted by function fitting to obtain a new cubic function expression between the capacity at each gear and the corresponding open circuit voltage. Then, based on the updated total capacity and the known capacity distribution ratio, the corresponding capacity value of each gear may be calculated; then based on this function expression, the OCV corresponding to each capacity may be calculated; and then the relationship among each current gear of the electrochromic device, the capacity of the electrochromic device, and the open circuit voltage of the electrochromic device may be re-determined for subsequent gear shift operations.

Of course, as an optional solution, in order to obtain the relationship between the capacity of each gear and the corresponding open circuit voltage of the current electrochromic device, it is also possible to adjust the device again and again so that multiple preset gears are reached in turn, and when the corresponding OCV of the corresponding gear is reached, the corresponding capacity is monitored. Thus, the corresponding relationship between the new capacity of each gear and the OCV may also be obtained directly.

It can be understood that for the solution where multiple gears are reached by the adjustment of the device again and again to obtain a new corresponding relationship, when too many gears exist, the workload of detection is large, and measurement errors are prone to occur; however, with the preceding solution of function fitting, it only needs to measure point values of more than four points at will, which greatly reduces the workload of detection and errors in gear measurement and improves the accuracy of device regulation and control.

As an optional solution, for S210, the electrochromic device in this embodiment may store multiple temperature ranges for dividing temperature values in advance, and the multiple temperature ranges include an extreme temperature range, a normal temperature range, and an intermediate temperature range other than the normal temperature range and the extreme temperature range. For example, the normal temperature range may be configured to be 0°C to 40°C, the extreme temperature range may be configured to be below -10°C and above 80°C, and the intermediate temperature range may be configured to be, for example, -10°C to 0°C and 40°C to 80°C, which may also be adjusted according to actual needs, and ranges herein are just examples.

It can be understood that the exemplary options in embodiments described above apply to the present embodiment as well, so the description is not repeated herein.

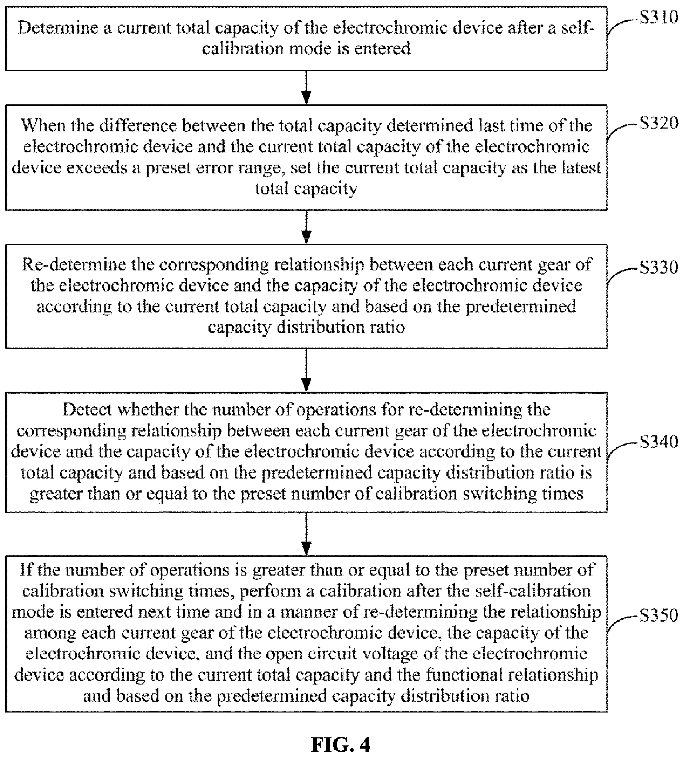

A detailed description of some embodiments of the present application is given below. With reference to FIG. 4, this embodiment proposes a calibration method for an electrochromic device. This method differs from the methods of the embodiments described above in that the preceding two calibration methods are alternately used for self-calibration in this embodiment. Specifically,, after the first calibration method of only updating the capacity is performed for a period of time or a certain number of times, the second calibration method of simultaneously updating the capacity and the OCV is performed once, and then the second calibration method is switched to the first calibration method, that is, the two calibration methods are alternatively used.

This is because the OCV corresponding to each gear does not change much within a period of time after a calibration, and when the capacity and the OCV are updated simultaneously, the waiting time is relatively long each time. Therefore, in this embodiment, a method is proposed where the first calibration method is executed for a certain period of time, and the second calibration method is performed once to achieve a balance between calibration accuracy and calibration efficiency.

Exemplarily, the calibration method for an electrochromic device includes the steps described below.

S310: A current total capacity of the electrochromic device is determined after a self-calibration mode is entered.

S320: When the difference between the total capacity determined last time of the electrochromic device and the current total capacity of the electrochromic device exceeds a preset error range, the current total capacity is set as the latest total capacity.

S330: The corresponding relationship between each current gear of the electrochromic device and the capacity of the electrochromic device is re-determined according to the current total capacity and based on the predetermined capacity distribution ratio.

S340: It is detected whether the number of operations for re-determining the corresponding relationship between each current gear of the electrochromic device and the capacity of the electrochromic device according to the current total capacity and based on the predetermined capacity distribution ratio is greater than or equal to the preset number of calibration switching times.

S350: If the number of operations is greater than or equal to the preset number of calibration switching times, a calibration is performed after the self-calibration mode is entered next time and in a manner of re-determining the relationship among each current gear of the electrochromic device, the capacity of the electrochromic device, and the open circuit voltage of the electrochromic device according to the current total capacity and the functional relationship and based on the predetermined capacity distribution ratio.

Exemplarily, it is detected whether the number of operations of S330 exceeds the preset number of calibration switching times, and if the number of operations exceeds the preset number of calibration switching times, the first calibration method is switched to the second calibration method for a one-time calibration at the next self-calibration. Then, at the next self-calibration after the next self-calibration, the second calibration method is switched to the first calibration method to perform multiple calibrations. The above is cycled so that the self-calibration operation is continuously performed.

The one-time self-calibration process in the manner where the relationship among each current gear of the electrochromic device, the capacity of the electrochromic device, and the open circuit voltage of the electrochromic device is re-determined according to the current total capacity and the functional relationship and based on the predetermined capacity distribution ratio is the same as that of S230 to S250 described above, and the description is not repeated herein.

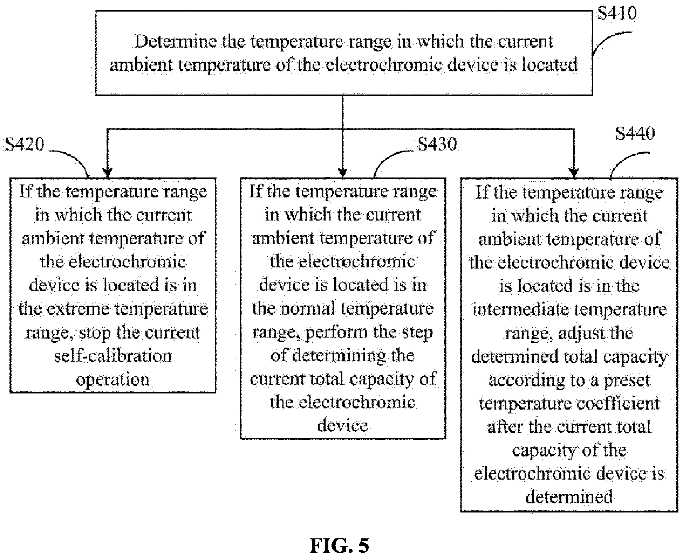

As an optional solution to the standard method described in any of the preceding embodiments, as shown in FIG. 5, the method also includes the steps described below after the self-calibration mode is entered in an embodiment.

S410: The temperature range in which the current ambient temperature of the electrochromic device is located is determined.

S420: If the temperature range in which the current ambient temperature of the electrochromic device is located is in the extreme temperature range, the current self-calibration operation is stopped.

S430: If the temperature range in which the current ambient temperature of the electrochromic device is located is in the normal temperature range, the step described above of determining the current total capacity of the electrochromic device is performed, that is, the subsequent self-calibration operation is performed normally.

S440: If the temperature range in which the current ambient temperature of the electrochromic device is located is in the intermediate temperature range, the determined current total capacity is adjusted according to a preset temperature coefficient after the current total capacity of the electrochromic device is determined.

Exemplarily, the calibration may be allowed when the current ambient temperature of the electrochromic device is in the intermediate temperature range, but the determined total capacity needs to be adjusted in a certain proportion to ensure the accuracy of the final calibration result. Generally, a linear relationship exists between the total capacity and the temperature coefficient. Specifically, according to the standard capacity measured at normal temperature and stored in the device, when the ambient temperature is high or low, the total capacity Q determined at this time may be converted to the total capacity Q_{N} at normal temperature according to the linear relationship described above, and the total capacity Q_{N} may be used as the adjusted total capacity determined at this time for subsequent calculation and analysis.

It can be understood that a poor external environment has a big influence on the performance of the device, and performing self-calibration in this case may affect the accuracy of the calibration result. Therefore, in this embodiment, whether the calibration is continued and whether the obtained result needs to be adjusted are determined by consideration of the current external environment of the device. In this manner, more accurate calibration of the device can be achieved in different states, thereby improving the user experience and the service life of the device.

It can be understood that the optional options in embodiments described above apply to this embodiment as well, so the description is not repeated herein.

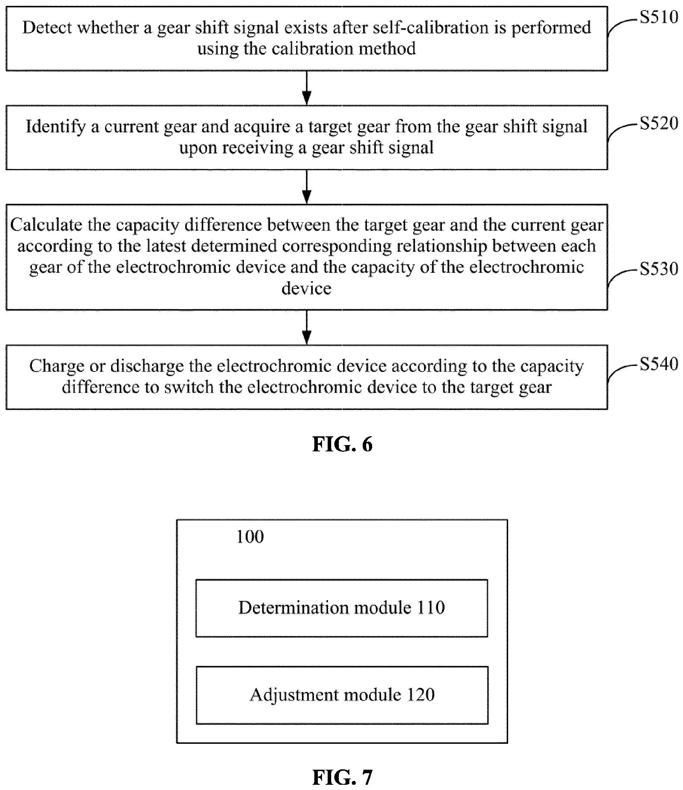

A detailed description of some embodiments of the present application is given below. With reference to FIG. 6, a method for controlling an electrochromic device is proposed in this embodiment based on the methods described in the preceding embodiments. Exemplarily, the method for controlling an electrochromic device includes the steps described below.

S510: It is detected whether a gear shift signal exists after self-calibration is performed using the calibration method described above.

S520: A current gear is identified and a target gear is acquired from the gear shift signal upon receiving a gear shift signal.

Exemplarily, when the gear shift signal is received, the current gear information is identified by comparison of a read OCV with the OCV in the corresponding relationship, which is obtained after self-calibration, between the capacity at each gear and the OCV of the device obtained after self-calibration. It can be understood that since the charge in a device that is not in a charge or discharge state tends to be uniformly distributed, a more accurate OCV value is able to be measured. For the target gear, the gear shift signal usually carries information about the target gear so that the gear shift signal may be directly analyzed to obtain the target gear.

S530: The capacity difference between the target gear and the current gear is calculated according to the latest determined corresponding relationship between each gear of the electrochromic device and the capacity of the electrochromic device.

S540: The electrochromic device is charged or discharged according to the capacity difference to switch the electrochromic device to the target gear.

Exemplarily, the charge capacities of the target gear and the current gear may be differenced to obtain a capacity difference. If the capacity difference is positive, it indicates that a charge is required; otherwise, a discharge is required. Therefore, the gear shift and adjustment are performed according to the corresponding charge or discharge operation. For example, the adjustment may be performed in a constant voltage or constant current manner, which is not specifically limited.

A detailed description of some embodiments of the present application is given below. With reference to FIG. 7, a calibration apparatus 100 for an electrochromic device is proposed in this embodiment. Exemplarily, the calibration apparatus 100 for an electrochromic device includes the modules below.

A determination module 110 is configured to determine the current total capacity of the electrochromic device after a self-calibration mode is entered.

A adjustment module 120 is configured to set the current total capacity as the latest total capacity when the difference between the total capacity of the electrochromic device determined last time and the current total capacity of the electrochromic device exceeds a preset error range and re-determine a corresponding relationship between each current gear of the electrochromic device and a capacity of the electrochromic device according to the current total capacity and based on a predetermined capacity distribution ratio.

Optionally, the calibration apparatus 100 for an electrochromic device further include the modules below.

An acquisition module is configured to charge the electrochromic device with a charge capacity of a preset distribution ratio each time according to the preset number of charging times, wait for a preset period after charging, and measure and record a current open circuit voltage of the electrochromic device after each charge to obtain multiple sets of measurement data of a current capacity of the electrochromic device and a corresponding open circuit voltage.

A fitting module is configured to fit the multiple sets of measurement data to obtain the functional relationship between the capacities and the open circuit voltages. At this time, the adjustment module 120 is configured to re-determine the relationship among each current gear of the electrochromic device, the capacity of the electrochromic device, and the open circuit voltage of the electrochromic device according to the current total capacity and the functional relationship and based on the predetermined capacity distribution ratio.

Optionally, the calibration apparatus 100 for an electrochromic device further include the module below.

A switch module is configured to, when the number of operations performed by the adjustment module 120 to re-determine the corresponding relationship between each current gear of the electrochromic device and the capacity of the electrochromic device according to the current total capacity and based on the predetermined capacity distribution ratio is greater than or equal to the preset number of calibration switching times, switch to perform a calibration after the self-calibration mode is entered next time and in a manner of re-determining the relationship among each current gear of the electrochromic device, the capacity of the electrochromic device, and the open circuit voltage of the electrochromic device according to the current total capacity and the functional relationship and based on the predetermined capacity distribution ratio.

The predetermined capacity distribution ratio and the initial corresponding relationship between each gear of the electrochromic device and the capacity are obtained in advance. Optionally, the calibration apparatus 100 for an electrochromic device further includes the module below.

A measurement module is configured to charge and discharge the electrochromic device and measure open circuit voltages and capacities of the electrochromic device at different transmittances to obtain the initial corresponding relationship among each gear of the electrochromic device, the open circuit voltage of the electrochromic device, and the capacity of the electrochromic device, where different transmittances correspond to different gears; then obtain the capacity distribution ratio corresponding to each gear of the electrochromic device according to the ratio of the capacity corresponding to each gear to the total capacity of the electrochromic device at a corresponding measurement stage.

In another embodiment, the measurement module may also be configured to perform capacity distribution on each gear according to the number of gears of the electrochromic device and based on the set capacity distribution ratio to obtain the capacity corresponding to each gear; charge and discharge the electrochromic device, monitor the current capacities of the electrochromic device, and when the monitored current capacities are separately equal to distributed capacities, record corresponding open circuit voltages to obtain the initial corresponding relationship among each gear of the electrochromic device, the open circuit voltage of the electrochromic device, and the capacity of the electrochromic device.

The determination module 110 includes a charge-discharge control sub-module and a recording sub-module. When the current total capacity of the electrochromic device is determined, in an embodiment, the charge-discharge control sub-module is configured to discharge the electrochromic device until a full discharge state is reached and charge the electrochromic device until a full charge state is reached; the recording sub-module is configured to record a full charge capacity required by the electrochromic device from the full discharge state to the full charge state; the full charge capacity is used as the current total capacity of the electrochromic device.

In another embodiment, the charge-discharge control sub-module is configured to charge the electrochromic device until a full charge state is reached and discharge the electrochromic device until a full discharge state is reached; the recording sub-module is configured to record a full discharge capacity required by the electrochromic device from the full charge state to the full discharge state; the full discharge capacity is used as the current total capacity of the electrochromic device.

As an optional solution, the determination module 110 is further configured to, after the self-calibration mode is entered and before the current total capacity of the electrochromic device is determined, use a full charge test process or a full discharge test process corresponding to the smaller value as a test process for subsequently determining the current total capacity of the electrochromic device according to the minimum value of the full charge capacity and the full discharge capacity obtained from an initial test of the electrochromic device.

Optionally, the electrochromic device stores multiple temperature ranges for dividing temperature values, and the multiple temperature ranges include an extreme temperature range, a normal temperature range, and an intermediate temperature range other than the normal temperature range and the extreme temperature range. Exemplarily, the calibration apparatus 100 for an electrochromic device also includes a detection module, a stopping module, and an adjustment module.

The detection module is configured to determine the temperature range in which the current ambient temperature of the electrochromic device is located after the self-calibration mode is entered. The stopping module is configured to stop the self-calibration operation if the temperature range in which the current ambient temperature of the electrochromic device is located is in the extreme temperature range. The determination module 110 is also configured to perform the step of determining the current total capacity of the electrochromic device if the temperature range in which the current ambient temperature of the electrochromic device is located is in the normal temperature range, while the adjustment module is configured to, if the temperature range in which the current ambient temperature of the electrochromic device is located is in the intermediate temperature range, adjust the determined total capacity according to a preset temperature coefficient after the current total capacity of the electrochromic device is determined by the determination module 110.

It can be understood that the apparatus in this embodiment corresponds to embodiments of the calibration method for the electrochromic device described above, and alternative options in embodiments described above apply to this embodiment as well, so the description is not repeated herein.

The present application further provides an electrochromic device, which may be, for example, a device integrated with an integrated electrochromic material such as a dimming window, a windshield of an automobile, and the like. Exemplarily, the electrochromic device includes a processor and a memory. The memory stores a computer program. The processor, by running the computer program, causes a terminal device to perform the preceding methods or functions of each module in the apparatus described above.

The present application further provides a readable storage medium configured to store the computer program used in the electrochromic device described above.

It is to be understood that the apparatus and methods provided in embodiments of the present application may be implemented in other manners. The preceding apparatus embodiments are merely illustrative. For example, the flowcharts and structure diagrams in the drawings illustrate possible implementation of architectures, functions, and operations of the apparatuses, methods, and computer program products according to the embodiments of the present application. In this regard, each block in a flowchart or block diagram may represent a part of a module, a program segment, or codes. The part of the module, the program segment, or codes contains one or more executable instructions for implementing specified logical functions. It is to be noted that in alternative embodiments, functions noted in the blocks may take an order different from that noted in the drawings. For example, two sequential blocks may, in fact, be executed substantially concurrently, or sometimes executed in the reverse order, which depends on the involved functions. It is to be noted that each block in the structure diagrams and/or flowcharts, and combinations of blocks in the structure diagrams and/or flowcharts may be implemented by specific-purpose hardware-based systems that perform specified functions or actions, or by combinations of specific-purpose hardware and computer instructions.

Additionally, functional modules or units in the embodiments of the present application may be integrated together to form an independent part, or each module may exist alone, or two or more modules may be integrated to form an independent part.

The functional modules may be stored in a computer-readable storage medium if implemented in the form of software function modules and sold or used as independent products. Based on this understanding, the technical solutions provided in this application substantially, the part contributing to the existing art, or part of the technical solutions may be embodied in the form of a software product. This computer software product is stored in a storage medium including several instructions for enabling a computer device (which may be a smart phone, a personal computer, a server, or a network device, etc.) to perform all or part of the steps in the methods provided in embodiments of this application. The preceding storage medium may include a U disk, a mobile hard disk, a read-only memory (ROM, Read-Only Memory), a random-access memory (RAM, Random Access Memory), a magnetic disk, an optical disk, or another medium that can store program codes.

In summary, the above are only specific embodiments of the present application and are not intended to limit the present application. The scope of the protection of the invention is defined by the appended claims.

## Claims

1. A calibration method for an electrochromic device, the calibration method comprises:
determining (110, 210, 310) a current total capacity of the electrochromic device after a self-calibration mode is entered; and
in response to a difference between a total capacity of the electrochromic device determined last time and the current total capacity of the electrochromic device exceeding a preset error range,
**characterized in that** the calibration method comprises setting (130) the current total capacity as a latest total capacity, and according to the current total capacity and based on a predetermined capacity distribution ratio, re-determining a corresponding relationship between each current gear of the electrochromic device and a capacity of the electrochromic device.

2. The calibration method for the electrochromic device of claim 1, wherein after setting the current total capacity as the latest total capacity, the calibration method further comprises:
charging (230) the electrochromic device with a charge capacity of a preset distribution ratio each time according to a preset number of charging times, waiting for a preset period after charging, and measuring and recording a current open circuit voltage of the electrochromic device after each charge to obtain a plurality of sets of measurement data of a current capacity and a corresponding open circuit voltage of the electrochromic device;
fitting (240) the plurality of sets of measurement data to obtain a functional relationship between capacities and open circuit voltages; and
re-determining (250) a relationship among the each current gear of the electrochromic device, the capacity of the electrochromic device, and an open circuit voltage of the electrochromic device according to the current total capacity and the functional relationship and based on the predetermined capacity distribution ratio.

3. The calibration method for the electrochromic device of claim 2, wherein the calibration method further comprises:
each time a number of operations of re-determining the corresponding relationship between the each current gear of the electrochromic device and the capacity of the electrochromic device according to the current total capacity and based on the predetermined capacity distribution ratio is greater than or equal to a preset number of calibration switching times, performing (350) a calibration after the self-calibration mode is entered next time and in a manner of re-determining the relationship among the each current gear of the electrochromic device, the capacity of the electrochromic device, and the open circuit voltage of the electrochromic device according to the current total capacity and the functional relationship and based on the predetermined capacity distribution ratio.

4. The calibration method for the electrochromic device of any one of claims 1 to 3, wherein the predetermined capacity distribution ratio and an initial corresponding relationship between each gear and the capacity of the electrochromic device are obtained in advance in one of the following manners:
charging and discharging the electrochromic device, and measuring corresponding open circuit voltages and capacities of the electrochromic device at different transmittances to obtain an initial corresponding relationship among the each gear of the electrochromic device, an open circuit voltage of the electrochromic device, and the capacity of the electrochromic device, wherein different transmittances correspond to different gears; and obtaining a capacity distribution ratio corresponding to the each gear of the electrochromic device according to a ratio of a capacity corresponding to the each gear of the electrochromic device to a total capacity of the electrochromic device at a corresponding measurement stage; or
performing capacity distribution on the each gear according to a number of gears of the electrochromic device and based on a set capacity distribution ratio to obtain a capacity corresponding to the each gear; and charging and discharging the electrochromic device, monitoring current capacities of the electrochromic device, and in response to the monitored current capacities being separately equal to distributed capacities, recording corresponding open circuit voltages to obtain an initial corresponding relationship among the each gear of the electrochromic device, an open circuit voltage of the electrochromic device, and the capacity of the electrochromic device; or
performing capacity distribution on the each gear according to a number of gears of the electrochromic device and based on a set capacity distribution ratio to obtain a capacity corresponding to the each gear; and selecting capacities corresponding to part gears for testing, and according to a test result, obtaining an initial corresponding relationship among the each gear of the electrochromic device, an open circuit voltage of the electrochromic device, and a capacity of the electrochromic device by function fitting.

5. The calibration method for the electrochromic device of claim 1, wherein determining the current total capacity of the electrochromic device comprises:
discharging the electrochromic device until a full discharge state is reached, charging the electrochromic device until a full charge state is reached, and recording a full charge capacity required by the electrochromic device from the full discharge state to the full charge state, wherein the full charge capacity is used as the current total capacity of the electrochromic device; or
charging the electrochromic device until a full charge state is reached, discharging the electrochromic device until a full discharge state is reached, and recording a full discharge capacity required by the electrochromic device from the full charge state to the full discharge state, wherein the full discharge capacity is used as the current total capacity of the electrochromic device.

6. The calibration method for the electrochromic device of claim 5, wherein before determining the current total capacity of the electrochromic device, the calibration method further comprises:
according to a smaller value of the full charge capacity and the full discharge capacity obtained from an initial test of the electrochromic device, using a full charge test process or a full discharge test process corresponding to the smaller value as a test process for subsequently determining the current total capacity of the electrochromic device.

7. The calibration method for the electrochromic device of any one of claims 1 to 6, wherein the electrochromic device is triggered to enter the self-calibration mode when any one or a combination of the following triggering conditions is satisfied:
when a total number of gear shifts reaches a preset number threshold; when a time interval from a last calibration reaches a preset time threshold; when a use time of the electrochromic device reaches a preset use time threshold; when a current gear shift operation is not completed when a maximum gear shift duration is exceeded; and when a difference between an open circuit voltage after completion of a current gear shift and an open circuit voltage corresponding to a target gear is not within a preset voltage difference range.

8. The calibration method for the electrochromic device of any one of claims 1 to 7, wherein the electrochromic device stores a plurality of temperature ranges for dividing temperature values, the plurality of temperature ranges comprise an extreme temperature range, a normal temperature range, and an intermediate temperature range other than the normal temperature range and the extreme temperature range, and after the self-calibration mode is entered, the method further comprises:
determining (410) a temperature range in which a current ambient temperature of the electrochromic device is located; and
in a case where the temperature range in which the current ambient temperature of the electrochromic device is located is in the extreme temperature range, stopping (420) a current self-calibration operation;
in a case where the temperature range in which the current ambient temperature of the electrochromic device is located is in the normal temperature range, performing (430) a step of determining the current total capacity of the electrochromic device;
in a case where the temperature range in which the current ambient temperature of the electrochromic device is located is in the intermediate temperature range, adjusting (450) the determined current total capacity according to a preset temperature coefficient after the current total capacity of the electrochromic device is determined.

9. A method for controlling an electrochromic device, wherein the method comprises:
detecting (510) whether a gear shift signal exists after self-calibration is performed using the calibration method of any one of claims 1 to 8;
identifying (520) a current gear and acquiring a target gear from the gear shift signal upon receiving a gear shift signal;
calculating (530) a capacity difference between the target gear and the current gear according to a latest determined corresponding relationship between each gear and a capacity of the electrochromic device; and
charging or discharging (540) the electrochromic device according to the capacity difference to switch the electrochromic device to the target gear.

10. A calibration apparatus for an electrochromic device, the calibration apparatus comprises:
a determination module (110), configured to determine a current total capacity of the electrochromic device after a self-calibration mode is entered; and
an adjustment module (120), configured to set the current total capacity as a latest total capacity in response to a difference between a total capacity of the electrochromic device determined last time and the current total capacity of the electrochromic device exceeding a preset error range, and re-determine a corresponding relationship between each current gear of the electrochromic device and a capacity of the electrochromic device according to the current total capacity and based on a predetermined capacity distribution ratio.

11. The calibration apparatus for the electrochromic device of claim 10, wherein the determination module comprises: a charge-discharge control sub-module, configured to, in response to the current total capacity of the electrochromic device being determined, discharge the electrochromic device until a full discharge state is reached, and charge the electrochromic device until a full charge state is reached; and a recording sub-module, configured to record a full charge capacity required by the electrochromic device from the full discharge state to the full charge state, wherein the full charge capacity is used as the current total capacity of the electrochromic device; or
the determination module comprises: a charge-discharge control sub-module, configured to, in response to the current total capacity of the electrochromic device being determined, charge the electrochromic device until a full charge state is reached, and discharge the electrochromic device until a full discharge state is reached; and a recording sub-module, configured to record a full discharge capacity required by the electrochromic device from the full charge state to the full discharge state, wherein the full discharge capacity is used as the current total capacity of the electrochromic device.

12. The calibration apparatus for the electrochromic device of any one of claims 10 to 11, wherein the calibration apparatus further comprises:
an acquisition module, configured to charge the electrochromic device with a charge capacity of a preset distribution ratio each time according to a preset number of charging times, wait for a preset period after charging, and measure and record a current open circuit voltage of the electrochromic device after each charge to obtain a plurality of sets of measurement data of a current capacity of the electrochromic device and a corresponding open circuit voltage; and
a fitting module, configured to fit the plurality of sets of measurement data to obtain a functional relationship between capacities and open circuit voltages; wherein the adjustment module is further configured to re-determine a relationship among the each current gear of the electrochromic device, the capacity of the electrochromic device, and an open circuit voltage of the electrochromic device according to the current total capacity and the functional relationship and based on the predetermined capacity distribution ratio.

13. The calibration apparatus for the electrochromic device of claim 12, wherein the calibration apparatus further comprises:
a switch module, configured to, in response to a number of operations performed by the adjustment module to re-determine the corresponding relationship between the each current gear of the electrochromic device and the capacity of the electrochromic device according to the current total capacity and based on the predetermined capacity distribution ratio being greater than or equal to a preset number of calibration switching times, switch to perform a calibration after the self-calibration mode is entered next time and in a manner of re-determining the relationship among the each current gear of the electrochromic device, the capacity of the electrochromic device, and the open circuit voltage of the electrochromic device according to the current total capacity and the functional relationship and based on the predetermined capacity distribution ratio.

14. The calibration apparatus for the electrochromic device of any one of claims 10 to 13, wherein the calibration apparatus further comprises:
a measurement module, configured to charge and discharge the electrochromic device, and
measure corresponding open circuit voltages and capacities of the electrochromic device at different transmittances to obtain an initial corresponding relationship among the each gear of the electrochromic device, an open circuit voltage of the electrochromic device, and the capacity of the electrochromic device; and obtain a capacity distribution ratio corresponding to the each gear of the electrochromic device according to a ratio of a capacity corresponding to the each gear of the electrochromic device to a total capacity of the electrochromic device at a corresponding measurement stage; or
a measurement module, configured to perform capacity distribution on the each gear according to a number of gears of the electrochromic device and based on a set capacity distribution ratio to obtain a capacity corresponding to the each gear; and charge and discharge the electrochromic device, monitor current capacities of the electrochromic device, and in response to the monitored current capacities being separately equal to distributed capacities, record a corresponding open circuit voltages to obtain an initial corresponding relationship among the each gear of the electrochromic device, an open circuit voltage of the electrochromic device, and the capacity of the electrochromic device.

15. An electrochromic device, wherein the electrochromic device comprises a processor and a memory, wherein the memory stores a computer program, and the processor is configured to execute the computer program to implement the method of any one of claims 1 to 9.

16. A computer-readable storage medium storing a computer program which, when executed by a processor of an electrochromic device, implements the method of any one of claims 1 to 9.

## Patentansprüche

1. Kalibrierungsverfahren für eine elektrochrome Vorrichtung, wobei das Kalibrierungsverfahren Folgendes umfasst:
Bestimmen (110, 210, 310) einer aktuellen Gesamtkapazität der elektrochromen Vorrichtung nach dem Eintritt in einen Selbstkalibrierungsmodus; und
als Reaktion darauf, dass eine Differenz zwischen einer beim letzten Mal bestimmten Gesamtkapazität der elektrochromen Vorrichtung und der aktuellen Gesamtkapazität der elektrochromen Vorrichtung einen voreingestellten Fehlerbereich überschreitet, **dadurch gekennzeichnet, dass** das Kalibrierungsverfahren das Einstellen (130) der aktuellen Gesamtkapazität als neueste Gesamtkapazität und gemäß der aktuellen Gesamtkapazität und bezogen auf ein vorbestimmtes Kapazitätsverteilungsverhältnis das erneute Bestimmen einer entsprechenden Beziehung zwischen jeder aktuellen Stufe der elektrochromen Vorrichtung und einer Kapazität der elektrochromen Vorrichtung umfasst.

2. Kalibrierungsverfahren für die elektrochrome Vorrichtung nach Anspruch 1, wobei das Kalibrierungsverfahren nach dem Einstellen der aktuellen Gesamtkapazität als neueste Gesamtkapazität ferner Folgendes umfasst:
Laden (230) der elektrochromen Vorrichtung mit einer Ladekapazität eines voreingestellten Kapazitätsverteilungsverhältnisses bei jedem Ladevorgang gemäß einer voreingestellten Anzahl von Ladevorgängen, Warten für einen voreingestellten Zeitraum nach dem Laden und Messen und Aufzeichnen einer aktuellen Leerlaufspannung der elektrochromen Vorrichtung nach jedem Laden, um eine Vielzahl von Messdatensätzen einer aktuellen Kapazität und einer entsprechenden Leerlaufspannung der elektrochromen Vorrichtung zu erhalten;
Anpassen (240) der Vielzahl von Messdatensätzen, um eine funktionale Beziehung zwischen Kapazitäten und Leerlaufspannungen zu erhalten; und
erneutes Bestimmen (250) einer Beziehung zwischen jeder aktuellen Stufe der elektrochromen Vorrichtung, der Kapazität der elektrochromen Vorrichtung und einer Leerlaufspannung der elektrochromen Vorrichtung gemäß der aktuellen Gesamtkapazität und der funktionalen Beziehung und bezogen auf das vorbestimmte Kapazitätsverteilungsverhältnis.

3. Kalibrierungsverfahren für die elektrochrome Vorrichtung nach Anspruch 2, wobei das Kalibrierungsverfahren ferner Folgendes umfasst:
immer dann, wenn eine Anzahl von Vorgängen des erneuten Bestimmens der entsprechenden Beziehung zwischen jeder aktuellen Stufe der elektrochromen Vorrichtung und der Kapazität der elektrochromen Vorrichtung gemäß der aktuellen Gesamtkapazität und bezogen auf das vorbestimmte Kapazitätsverteilungsverhältnis größer oder gleich einer voreingestellten Anzahl von Kalibrierungsumschaltvorgängen ist, Durchführen (350) einer Kalibrierung nach dem nächsten Eintritt in den Selbstkalibrierungsmodus und durch erneutes Bestimmen der Beziehung zwischen jeder aktuellen Stufe der elektrochromen Vorrichtung, der Kapazität der elektrochromen Vorrichtung und der Leerlaufspannung der elektrochromen Vorrichtung gemäß der aktuellen Gesamtkapazität und der funktionalen Beziehung und bezogen auf das vorbestimmte Kapazitätsverteilungsverhältnis.

4. Kalibrierungsverfahren für die elektrochrome Vorrichtung nach einem der Ansprüche 1 bis 3, wobei das vorbestimmte Kapazitätsverteilungsverhältnis und eine initiale entsprechende Beziehung zwischen jeder Stufe und der Kapazität der elektrochromen Vorrichtung im Vorfeld auf eine der folgenden Weisen erhalten werden:
Laden und Entladen der elektrochromen Vorrichtung und Messen entsprechender Leerlaufspannungen und Kapazitäten der elektrochromen Vorrichtung bei unterschiedlichen Transmissionen, um eine initiale entsprechende Beziehung zwischen jeder Stufe der elektrochromen Vorrichtung, einer Leerlaufspannung der elektrochromen Vorrichtung und der Kapazität der elektrochromen Vorrichtung zu erhalten, wobei unterschiedliche Transmissionen unterschiedlichen Stufen entsprechen; und Erhalten eines Kapazitätsverteilungsverhältnisses entsprechend jeder Stufe der elektrochromen Vorrichtung gemäß einem Verhältnis einer Kapazität entsprechend jeder Stufe der elektrochromen Vorrichtung zu einer Gesamtkapazität der elektrochromen Vorrichtung in einer entsprechenden Messphase; oder
Durchführen einer Kapazitätsverteilung an jeder Stufe gemäß einer Anzahl von Stufen der elektrochromen Vorrichtung und bezogen auf ein eingestelltes Kapazitätsverteilungsverhältnis, um eine Kapazität entsprechend jeder Stufe zu erhalten; und Laden und Entladen der elektrochromen Vorrichtung, Überwachen aktueller Kapazitäten der elektrochromen Vorrichtung und als Reaktion darauf, dass die überwachten aktuellen Kapazitäten jeweils gleich verteilten Kapazitäten sind, Aufzeichnen entsprechender Leerlaufspannungen, um eine initiale entsprechende Beziehung zwischen jeder Stufe der elektrochromen Vorrichtung, einer Leerlaufspannung der elektrochromen Vorrichtung und der Kapazität der elektrochromen Vorrichtung zu erhalten; oder
Durchführen einer Kapazitätsverteilung an jeder Stufe gemäß einer Anzahl von Stufen der elektrochromen Vorrichtung und bezogen auf ein eingestelltes Kapazitätsverteilungsverhältnis, um eine Kapazität entsprechend jeder Stufe zu erhalten; und Auswählen von Kapazitäten, die einem Teil der Stufen entsprechen, zum Testen und gemäß einem Testergebnis Erhalten einer initialen entsprechenden Beziehung zwischen jeder Stufe der elektrochromen Vorrichtung, einer Leerlaufspannung der elektrochromen Vorrichtung und einer Kapazität der elektrochromen Vorrichtung durch Funktionsanpassung.

5. Kalibrierungsverfahren für die elektrochrome Vorrichtung nach Anspruch 1, wobei das Bestimmen der aktuellen Gesamtkapazität der elektrochromen Vorrichtung Folgendes umfasst:
Entladen der elektrochromen Vorrichtung, bis ein Vollentladezustand erreicht ist, Laden der elektrochromen Vorrichtung, bis ein Vollladezustand erreicht ist, und Aufzeichnen einer vom Vollentladezustand bis zum Vollladezustand durch die elektrochrome Vorrichtung benötigten Vollladekapazität, wobei die Vollladekapazität als aktuelle Gesamtkapazität der elektrochromen Vorrichtung herangezogen wird; oder
Laden der elektrochromen Vorrichtung, bis ein Vollladezustand erreicht ist, Entladen der elektrochromen Vorrichtung, bis ein Vollentladezustand erreicht ist, und Aufzeichnen einer vom Vollladezustand bis zum Vollentladezustand durch die elektrochrome Vorrichtung benötigten Vollentladekapazität, wobei die Vollentladekapazität als aktuelle Gesamtkapazität der elektrochromen Vorrichtung herangezogen wird.

6. Kalibrierungsverfahren für die elektrochrome Vorrichtung nach Anspruch 5, wobei das Kalibrierungsverfahren vor dem Bestimmen der aktuellen Gesamtkapazität der elektrochromen Vorrichtung ferner Folgendes umfasst:
gemäß einem anhand eines initialen Tests der elektrochromen Vorrichtung erhaltenen kleineren Wert der Vollladekapazität und der Vollentladekapazität Verwenden eines Vollladetestprozesses oder eines Vollentladetestprozesses entsprechend dem kleineren Wert als Testprozess für das anschließende Bestimmen der aktuellen Gesamtkapazität der elektrochromen Vorrichtung.

7. Kalibrierungsverfahren für die elektrochrome Vorrichtung nach einem der Ansprüche 1 bis 6, wobei die elektrochrome Vorrichtung ausgelöst wird, um in den Selbstkalibrierungsmodus einzutreten, wenn eine der folgenden Auslösebedingungen oder eine Kombination davon erfüllt ist:
wenn eine Gesamtanzahl von Stufenumschaltungen einen voreingestellten Anzahlschwellenwert erreicht; wenn ein Zeitintervall von einer letzten Kalibrierung eine voreingestellte Zeitschwelle erreicht; wenn eine Nutzungsdauer der elektrochromen Vorrichtung einen voreingestellten Nutzungsdauerschwellenwert erreicht; wenn ein aktueller Stufenumschaltvorgang bei Überschreiten einer maximalen Stufenumschaltdauer nicht abgeschlossen ist; und wenn eine Differenz zwischen einer Leerlaufspannung nach dem Abschluss einer aktuellen Stufenumschaltung und einer Leerlaufspannung entsprechend einer Zielstufe nicht innerhalb eines voreingestellten Spannungsdifferenzbereichs liegt.

8. Kalibrierungsverfahren für die elektrochrome Vorrichtung nach einem der Ansprüche 1 bis 7, wobei die elektrochrome Vorrichtung eine Vielzahl von Temperaturbereichen zur Aufteilung von Temperaturwerten speichert, die Vielzahl von Temperaturbereichen einen extremen Temperaturbereich, einen normalen Temperaturbereich und einen Zwischentemperaturbereich umfasst, der weder der normale noch der extreme Temperaturbereich ist, und das Verfahren nach dem Eintritt in den Selbstkalibrierungsmodus ferner Folgendes umfasst:
Bestimmen (410) eines Temperaturbereichs, in dem sich eine aktuelle Umgebungstemperatur der elektrochromen Vorrichtung befindet; und
Stoppen (420) eines aktuellen Selbstkalibrierungsvorgangs, sofern der Temperaturbereich, in dem sich die aktuelle Umgebungstemperatur der elektrochromen Vorrichtung befindet, der extreme Temperaturbereich ist;
Durchführen (430) eines Schritts des Bestimmens der aktuellen Gesamtkapazität der elektrochromen Vorrichtung, sofern der Temperaturbereich, in dem sich die aktuelle Umgebungstemperatur der elektrochromen Vorrichtung befindet, der normale Temperaturbereich ist;
Korrigieren (450) der bestimmten aktuellen Gesamtkapazität gemäß einem voreingestellten Temperaturkoeffizienten nach dem Bestimmen der aktuellen Gesamtkapazität der elektrochromen Vorrichtung, sofern der Temperaturbereich, in dem sich die aktuelle Umgebungstemperatur der elektrochromen Vorrichtung befindet, der Zwischentemperaturbereich ist.

9. Verfahren zur Steuerung einer elektrochromen Vorrichtung, wobei das Verfahren Folgendes umfasst:
Erkennen (510), ob nach dem Durchführen einer Selbstkalibrierung mithilfe des Kalibrierungsverfahrens nach einem der Ansprüche 1 bis 8 ein Stufenumschaltsignal vorliegt;
Identifizieren (520) einer aktuellen Stufe und Erfassen einer Zielstufe anhand des Stufenumschaltsignals beim Empfangen eines Stufenumschaltsignals;
Berechnen (530) einer Kapazitätsdifferenz zwischen der Zielstufe und der aktuellen Stufe gemäß einer zuletzt bestimmten entsprechenden Beziehung zwischen jeder Stufe und einer Kapazität der elektrochromen Vorrichtung; und
Laden oder Entladen (540) der elektrochromen Vorrichtung gemäß der Kapazitätsdifferenz zur Umschaltung der elektrochromen Vorrichtung auf die Zielstufe.

10. Kalibrierungseinrichtung für eine elektrochrome Vorrichtung, wobei die Kalibrierungseinrichtung Folgendes umfasst:
ein Bestimmungsmodul (110), das zum Bestimmen einer aktuellen Gesamtkapazität der elektrochromen Vorrichtung nach dem Eintritt in einen Selbstkalibrierungsmodus ausgelegt ist; und
ein Korrekturmodul (120), das zum Einstellen der aktuellen Gesamtkapazität als neueste Gesamtkapazität als Reaktion darauf, dass eine Differenz zwischen einer beim letzten Mal bestimmten Gesamtkapazität der elektrochromen Vorrichtung und der aktuellen Gesamtkapazität der elektrochromen Vorrichtung einen voreingestellten Fehlerbereich überschreitet, und zum erneuten Bestimmen einer entsprechenden Beziehung zwischen jeder aktuellen Stufe der elektrochromen Vorrichtung und einer Kapazität der elektrochromen Vorrichtung gemäß der aktuellen Gesamtkapazität und bezogen auf ein vorbestimmtes Kapazitätsverteilungsverhältnis ausgelegt ist.

11. Kalibrierungseinrichtung für die elektrochrome Vorrichtung nach Anspruch 10, wobei das Bestimmungsmodul Folgendes umfasst: ein Lade-/Entladesteuerungsuntermodul, das als Reaktion auf das Bestimmen der aktuellen Gesamtkapazität der elektrochromen Vorrichtung zum Entladen der elektrochromen Vorrichtung, bis ein Vollentladezustand erreicht ist, und zum Laden der elektrochromen
Vorrichtung, bis ein Vollladezustand erreicht ist, ausgelegt ist; und ein Aufzeichnungsuntermodul, das zum Aufzeichnen einer vom Vollentladezustand bis zum Vollladezustand durch die elektrochrome Vorrichtung benötigten Vollladekapazität ausgelegt ist, wobei die Vollladekapazität als aktuelle Gesamtkapazität der elektrochromen Vorrichtung herangezogen wird;
oder das Bestimmungsmodul Folgendes umfasst: ein Lade-/Entladesteuerungsuntermodul, das als Reaktion auf das Bestimmen der aktuellen Gesamtkapazität der elektrochromen Vorrichtung zum Laden der elektrochromen Vorrichtung, bis ein Vollladezustand erreicht ist, und zum Entladen der elektrochromen Vorrichtung, bis ein Vollentladezustand erreicht ist, ausgelegt ist; und ein Aufzeichnungsuntermodul, das zum Aufzeichnen einer vom Vollladezustand bis zum Vollentladezustand durch die elektrochrome Vorrichtung benötigten Vollentladekapazität ausgelegt ist, wobei die Vollentladekapazität als aktuelle Gesamtkapazität der elektrochromen Vorrichtung herangezogen wird.

12. Kalibrierungseinrichtung für die elektrochrome Vorrichtung nach einem der Ansprüche 10 bis 11, wobei die Kalibrierungseinrichtung ferner Folgendes umfasst:
ein Erfassungsmodul, das zum Laden der elektrochromen Vorrichtung mit einer Ladekapazität eines voreingestellten Kapazitätsverteilungsverhältnisses bei jedem Ladevorgang gemäß einer voreingestellten Anzahl von Ladevorgängen, Warten für einen voreingestellten Zeitraum nach dem Laden und Messen und Aufzeichnen einer aktuellen Leerlaufspannung der elektrochromen Vorrichtung nach jedem Laden, um eine Vielzahl von Messdatensätzen einer aktuellen Kapazität der elektrochromen Vorrichtung und einer entsprechenden Leerlaufspannung zu erhalten, ausgelegt ist; und
ein Anpassungsmodul, das zum Anpassen der Vielzahl von Messdatensätzen, um eine funktionale Beziehung zwischen Kapazitäten und Leerlaufspannungen zu erhalten, ausgelegt ist; wobei das Korrekturmodul ferner zum erneuten Bestimmen einer Beziehung zwischen jeder aktuellen Stufe der elektrochromen Vorrichtung, der Kapazität der elektrochromen Vorrichtung und einer Leerlaufspannung der elektrochromen Vorrichtung gemäß der aktuellen Gesamtkapazität und der funktionalen Beziehung und bezogen auf das vorbestimmte Kapazitätsverteilungsverhältnis ausgelegt ist.

13. Kalibrierungseinrichtung für die elektrochrome Vorrichtung nach Anspruch 12, wobei die Kalibrierungseinrichtung ferner Folgendes umfasst:
ein Umschaltmodul, das dazu ausgelegt ist, als Reaktion darauf, dass eine Anzahl von Vorgängen, die durch das Korrekturmodul durchgeführt werden, um die entsprechende Beziehung zwischen jeder aktuellen Stufe der elektrochromen Vorrichtung und der Kapazität der elektrochromen Vorrichtung gemäß der aktuellen Gesamtkapazität und bezogen auf das vorbestimmte Kapazitätsverteilungsverhältnis erneut zu bestimmen, größer oder gleich einer voreingestellten Anzahl von Kalibrierungsumschaltvorgängen ist, umzuschalten, um eine Kalibrierung nach dem nächsten Eintreten in den Selbstkalibrierungsmodus und durch erneutes Bestimmen der Beziehung zwischen jeder aktuellen Stufe der elektrochromen Vorrichtung, der Kapazität der elektrochromen Vorrichtung und der Leerlaufspannung der elektrochromen Vorrichtung gemäß der aktuellen Gesamtkapazität und der funktionalen Beziehung und bezogen auf das vorbestimmte Kapazitätsverteilungsverhältnis durchzuführen.

14. Kalibrierungseinrichtung für die elektrochrome Vorrichtung nach einem der Ansprüche 10 bis 13, wobei die Kalibrierungseinrichtung ferner Folgendes umfasst:
ein Messmodul, das zum Laden und Entladen der elektrochromen Vorrichtung und Messen entsprechender Leerlaufspannungen und Kapazitäten der elektrochromen Vorrichtung bei unterschiedlichen Transmissionen, um eine initiale entsprechende Beziehung zwischen jeder Stufe der elektrochromen Vorrichtung, einer Leerlaufspannung der elektrochromen Vorrichtung und der Kapazität der elektrochromen Vorrichtung zu erhalten, und zum Erhalten eines Kapazitätsverteilungsverhältnisses entsprechend jeder Stufe der elektrochromen Vorrichtung gemäß einem Verhältnis einer Kapazität entsprechend jeder Stufe der elektrochromen Vorrichtung zu einer Gesamtkapazität der elektrochromen Vorrichtung in einer entsprechenden Messphase ausgelegt ist; oder
ein Messmodul, das zum Durchführen einer Kapazitätsverteilung an jeder Stufe gemäß einer Anzahl von Stufen der elektrochromen Vorrichtung und bezogen auf ein eingestelltes Kapazitätsverteilungsverhältnis, um eine Kapazität entsprechend jeder Stufe zu erhalten, und zum Laden und Entladen der elektrochromen Vorrichtung, zum Überwachen aktueller Kapazitäten der elektrochromen Vorrichtung und als Reaktion darauf, dass die überwachten aktuellen Kapazitäten jeweils gleich verteilten Kapazitäten sind, zum Aufzeichnen entsprechender Leerlaufspannungen, um eine initiale entsprechende Beziehung zwischen jeder Stufe der elektrochromen Vorrichtung, einer Leerlaufspannung der elektrochromen Vorrichtung und der Kapazität der elektrochromen Vorrichtung zu erhalten, ausgelegt ist.

15. Elektrochrome Vorrichtung, wobei die elektrochrome Vorrichtung einen Prozessor und einen Speicher umfasst, wobei der Speicher ein Computerprogramm speichert und der Prozessor ausgelegt ist, um das Computerprogramm zum Implementieren des Verfahrens nach einem der Ansprüche 1 bis 9 auszuführen.

16. Computerlesbares Speichermedium, das ein Computerprogramm speichert, das, wenn es durch einen Prozessor einer elektrochromen Vorrichtung ausgeführt wird, das Verfahren nach einem der Ansprüche 1 bis 9 implementiert.

## Revendications

1. Procédé d'étalonnage d'un dispositif électrochromique, le procédé d'étalonnage comprend :
la détermination (110, 210, 310) d'une capacité totale actuelle du dispositif électrochromique après entrée dans un mode d'auto-étalonnage ; et
en réponse à une différence entre une capacité totale du dispositif électrochromique déterminée la dernière fois et la capacité totale actuelle du dispositif électrochromique dépassant une plage d'erreur prédéfinie, **caractérisé en ce que** le procédé d'étalonnage comprend la définition (130) de la capacité totale actuelle comme capacité totale la plus récente et, en fonction de la capacité totale actuelle et sur la base d'un ratio de distribution de capacité prédéterminé, la détermination à nouveau d'une relation correspondante entre chaque niveau actuel du dispositif électrochromique et une capacité du dispositif électrochromique.

2. Procédé d'étalonnage pour le dispositif électrochromique selon la revendication 1, dans lequel, après avoir défini la capacité totale actuelle comme capacité totale la plus récente, le procédé d'étalonnage comprend en outre :
la charge (230) du dispositif électrochromique avec une capacité de charge d'un ratio de distribution prédéfini à chaque fois en fonction d'un nombre prédéfini de charges, l'attente pendant une période prédéfinie après la charge et la mesure et l'enregistrement d'une tension en circuit ouvert actuelle du dispositif électrochromique après chaque charge pour obtenir une pluralité d'ensembles de données de mesure d'une capacité actuelle et d'une tension en circuit ouvert correspondante du dispositif électrochromique ;
l'ajustement (240) de la pluralité d'ensembles de données de mesure pour obtenir une relation fonctionnelle entre les capacités et les tensions en circuit ouvert ; et
la détermination (250) à nouveau d'une relation entre chaque niveau actuel du dispositif électrochromique, la capacité du dispositif électrochromique et une tension en circuit ouvert du dispositif électrochromique en fonction de la capacité totale actuelle et de la relation fonctionnelle et sur la base du ratio de distribution de capacité prédéterminé.

3. Procédé d'étalonnage pour le dispositif électrochromique selon la revendication 2, dans lequel le procédé d'étalonnage comprend en outre :
chaque fois qu'un certain nombre d'opérations de détermination à nouveau de la relation correspondante entre chaque niveau actuel du dispositif électrochromique et la capacité du dispositif électrochromique en fonction de la capacité totale actuelle et sur la base du ratio de distribution de capacité prédéterminé est supérieur ou égal à un nombre prédéfini de commutations d'étalonnage, la réalisation (350) d'un étalonnage après l'entrée suivante dans le mode d'auto-étalonnage et de manière à redéterminer la relation entre chaque niveau actuel du dispositif électrochromique, la capacité du dispositif électrochromique et la tension en circuit ouvert du dispositif électrochromique en fonction de la capacité totale actuelle et de la relation fonctionnelle et sur la base du ratio de distribution de capacité prédéterminé.

4. Procédé d'étalonnage pour le dispositif électrochromique selon l'une quelconque des revendications 1 à 3, dans lequel le ratio de distribution de capacité prédéterminé et une relation correspondante initiale entre chaque niveau et la capacité du dispositif électrochromique sont obtenus à l'avance selon l'une des manières suivantes :
la charge et la décharge du dispositif électrochromique et la mesure des tensions en circuit ouvert et des capacités correspondantes du dispositif électrochromique à des transmittances différentes pour obtenir une relation correspondante initiale entre chaque niveau du dispositif électrochromique, une tension en circuit ouvert du dispositif électrochromique et la capacité du dispositif électrochromique, dans lequel des transmittances différentes correspondent à des niveaux différents ; et l'obtention d'un ratio de distribution de capacité correspondant à chaque niveau du dispositif électrochromique en fonction d'un ratio d'une capacité correspondant à chaque niveau du dispositif électrochromique par rapport à une capacité totale du dispositif électrochromique à une étape de mesure correspondant ; ou
la réalisation d'une distribution de capacité sur chaque niveau en fonction d'un nombre de niveaux du dispositif électrochromique et sur la base d'un ratio de distribution de capacité défini pour obtenir une capacité correspondant à chaque niveau ; et la charge et la décharge du dispositif électrochromique, la surveillance des capacités actuelles du dispositif électrochromique et, en réponse au fait que les capacités actuelles surveillées sont séparément égales aux capacités distribuées, l'enregistrement des tensions en circuit ouvert correspondantes pour obtenir une relation correspondante initiale entre chaque niveau du dispositif électrochromique, une tension en circuit ouvert du dispositif électrochromique et la capacité du dispositif électrochromique ; ou
la réalisation d'une distribution de capacité pour chaque niveau en fonction d'un nombre de niveaux du dispositif électrochromique et sur la base d'un ratio de distribution de capacité défini pour obtenir une capacité correspondant à chaque niveau ; et la sélection des capacités correspondant à certains niveaux pour essai et, en fonction d'un résultat d'essai, l'obtention d'une relation correspondante initiale entre chaque niveau du dispositif électrochromique, une tension en circuit ouvert du dispositif électrochromique et une capacité du dispositif électrochromique par ajustement fonctionnel.

5. Procédé d'étalonnage pour le dispositif électrochromique selon la revendication 1, dans lequel la détermination de la capacité totale actuelle du dispositif électrochromique comprend :
la décharge du dispositif électrochromique jusqu'à atteindre un état de décharge complète, la charge du dispositif électrochromique jusqu'à atteindre un état de charge complète et l'enregistrement d'une capacité de charge complète requise par le dispositif électrochromique à partir de l'état de décharge complète jusqu'à l'état de charge complète, dans lequel la capacité de charge complète est utilisée comme capacité totale actuelle du dispositif électrochromique ; ou
la charge du dispositif électrochromique jusqu'à atteindre un état de charge complète, la décharge du dispositif électrochromique jusqu'à atteindre un état de décharge complète et l'enregistrement d'une capacité de décharge complète requise par le dispositif électrochromique à partir de l'état de charge complète jusqu'à l'état de décharge complète, dans lequel la capacité de décharge complète est utilisée comme capacité totale actuelle du dispositif électrochromique.

6. Procédé d'étalonnage pour le dispositif électrochromique selon la revendication 5, dans lequel, avant la détermination de la capacité totale actuelle du dispositif électrochromique, le procédé d'étalonnage comprend en outre :
l'utilisation, en fonction de la plus petite valeur parmi la capacité de charge complète et la capacité de décharge complète obtenues lors d'un test initial du dispositif électrochromique, d'un processus de test de charge complète ou d'un processus de test de décharge complète correspondant à cette valeur la plus petite, comme processus de test pour déterminer ultérieurement de la capacité totale actuelle du dispositif électrochromique.

7. Procédé d'étalonnage pour le dispositif électrochromique selon l'une quelconque des revendications 1 à 6, dans lequel le dispositif électrochromique est déclenché pour entrer dans le mode d'auto-étalonnage lorsque l'une quelconque ou une combinaison des conditions de déclenchement suivantes est remplie :
lorsqu'un nombre total de changements de niveau atteint un seuil de nombre prédéfini ; lorsqu'un intervalle de temps à partir d'un dernier étalonnage atteint un seuil de temps prédéfini ; lorsqu'un temps d'utilisation du dispositif électrochromique atteint un seuil de temps d'utilisation prédéfini ; lorsqu'une opération de changement de niveau actuel n'est pas achevée lorsqu'une durée de changement de niveau maximale est dépassée ; et lorsqu'une différence entre une tension en circuit ouvert à l'issue d'un changement de niveau actuel et une tension en circuit ouvert correspondant à un niveau cible n'est pas dans une plage de différence de tension prédéfinie.

8. Procédé d'étalonnage pour le dispositif électrochromique selon l'une quelconque des revendications 1 à 7, dans lequel le dispositif électrochromique stocke une pluralité de plages de température pour la division de valeurs de température, la pluralité de plages de température comprend une plage de températures extrêmes, une plage de températures normales et une plage de températures intermédiaires autre que la plage de températures normales et la plage de températures extrêmes, et après entrée dans le mode d'auto-étalonnage, le procédé comprend en outre :
la détermination (410) d'une plage de température dans laquelle se trouve une température ambiante actuelle du dispositif électrochromique ; et
dans un cas où la plage de température dans laquelle se trouve la température ambiante actuelle du dispositif électrochromique est dans la plage de températures extrêmes, l'arrêt (420) de l'opération d'auto-étalonnage en cours ;
dans un cas où la plage de température dans laquelle se trouve la température ambiante actuelle du dispositif électrochromique est dans la plage de températures normales, la réalisation (430) d'une étape de détermination de la capacité totale actuelle du dispositif électrochromique ;
dans un cas où la plage de température dans laquelle se trouve la température ambiante actuelle du dispositif électrochromique est dans la plage de températures intermédiaires, le réglage (450) de la capacité totale actuelle déterminée en fonction d'un coefficient de température prédéfini après la détermination de la capacité totale actuelle du dispositif électrochromique.

9. Procédé de commande d'un dispositif électrochromique, dans lequel le procédé comprend :
la détection (510) de l'existence ou non d'un signal de changement de niveau après l'exécution de l'auto-étalonnage à l'aide du procédé d'étalonnage selon l'une quelconque des revendications 1 à 8 ;
l'identification (520) d'un niveau actuel et l'acquisition d'un niveau cible à partir du signal de changement de niveau à la réception d'un signal de changement de niveau ;
le calcul (530) d'une différence de capacité entre le niveau cible et le niveau actuel en fonction d'une relation correspondante déterminée la plus récente entre chaque niveau et une capacité du dispositif électrochromique ; et
la charge ou la décharge (540) du dispositif électrochromique en fonction de la différence de capacité pour commuter le dispositif électrochromique dans le niveau cible.

10. Appareil d'étalonnage pour un dispositif électrochromique, l'appareil d'étalonnage comprend :
un module de détermination (110), configuré pour déterminer une capacité totale actuelle du dispositif électrochromique après entrée dans un mode d'auto-étalonnage ; et
un module de réglage (120), configuré pour régler la capacité totale actuelle comme capacité totale la plus récente en réponse à une différence entre une capacité totale du dispositif électrochromique déterminée la dernière fois et la capacité totale actuelle du dispositif électrochromique dépassant une plage d'erreur prédéfinie, et déterminer à nouveau une relation correspondante entre chaque niveau actuel du dispositif électrochromique et une capacité du dispositif électrochromique en fonction de la capacité totale actuelle et sur la base d'un ratio de distribution de capacité prédéterminé.

11. Appareil d'étalonnage pour le dispositif électrochromique selon la revendication 10, dans lequel le module de détermination comprend : un sous-module de commande de charge-décharge, configuré, en réponse à la détermination de la capacité totale actuelle du dispositif électrochromique, pour décharger le dispositif électrochromique jusqu'à atteindre un état de décharge complète, et charger le dispositif électrochromique
jusqu'à atteindre un état de charge complète ; et un sous-module d'enregistrement, configuré pour enregistrer une capacité de charge complète requise par le dispositif électrochromique à partir de l'état de décharge complète jusqu'à l'état de charge complète, dans lequel la capacité de charge complète est utilisée comme capacité totale actuelle du dispositif électrochromique ; ou
le module de détermination comprend : un sous-module de commande de charge-décharge, configuré, en réponse à la détermination de la capacité totale actuelle du dispositif électrochromique, pour charger le dispositif électrochromique jusqu'à atteindre un état de charge complète, et décharger le dispositif électrochromique jusqu'à atteindre un état de décharge complète ; et un sous-module d'enregistrement, configuré pour enregistrer une capacité de décharge complète requise par le dispositif électrochromique à partir de l'état de charge complète jusqu'à l'état de décharge complète, dans lequel la capacité de décharge complète est utilisée comme capacité totale actuelle du dispositif électrochromique.

12. Appareil d'étalonnage pour le dispositif électrochromique selon l'une quelconque des revendications 10 à 11, dans lequel l'appareil d'étalonnage comprend en outre :
un module d'acquisition, configuré pour charger le dispositif électrochromique avec une capacité de charge d'un ratio de distribution prédéfini à chaque fois en fonction d'un nombre prédéfini de charges, attendre pendant une période prédéfinie après la charge et mesurer et enregistrer une tension en circuit ouvert actuelle du dispositif électrochromique après chaque charge pour obtenir une pluralité d'ensembles de données de mesure d'une capacité actuelle du dispositif électrochromique et une tension en circuit ouvert correspondante ; et
un module d'ajustement, configuré pour ajuster la pluralité d'ensembles de données de mesure afin d'obtenir une relation fonctionnelle entre les capacités et les tensions en circuit ouvert ; dans lequel le module de réglage est en outre configuré pour redéterminer une relation entre chaque niveau actuel du dispositif électrochromique, la capacité du dispositif électrochromique et une tension en circuit ouvert du dispositif électrochromique en fonction de la capacité totale actuelle et de la relation fonctionnelle et sur la base du ratio de distribution de capacité prédéterminé.

13. Appareil d'étalonnage pour le dispositif électrochromique selon la revendication 12, dans lequel l'appareil d'étalonnage comprend en outre :
un module de commutation, configuré, en réponse à un nombre d'opérations effectuées par le module de réglage pour déterminer à nouveau la relation correspondante entre chaque niveau actuel du dispositif électrochromique et la capacité du dispositif électrochromique en fonction de la capacité totale actuelle et sur la base du ratio de distribution de capacité prédéterminé étant supérieur ou égal à un nombre prédéfini de commutations d'étalonnage, pour commuter afin d'effectuer un étalonnage après l'entrée suivante dans le mode d'auto-étalonnage et de manière à redéterminer la relation entre chaque niveau actuel du dispositif électrochromique, la capacité du dispositif électrochromique et la tension en circuit ouvert du dispositif électrochromique en fonction de la capacité totale actuelle et de la relation fonctionnelle et sur la base du ratio de distribution de capacité prédéterminé.

14. Appareil d'étalonnage pour le dispositif électrochromique selon l'une quelconque des revendications 10 à 13, dans lequel l'appareil d'étalonnage comprend en outre :
un module de mesure, configuré pour charger et décharger le dispositif électrochromique et mesurer des tensions en circuit ouvert et des capacités correspondantes du dispositif électrochromique à des transmittances différentes pour obtenir une relation correspondante initiale entre chaque niveau du dispositif électrochromique, une tension en circuit ouvert du dispositif électrochromique et la capacité du dispositif électrochromique ; et obtenir un ratio de distribution de capacité correspondant à chaque niveau du dispositif électrochromique en fonction d'un ratio d'une capacité correspondant à chaque niveau du dispositif électrochromique par rapport à une capacité totale du dispositif électrochromique à une étape de mesure correspondant ; ou
un module de mesure, configuré pour effectuer une distribution de capacité pour chaque niveau en fonction d'un nombre de niveaux du dispositif électrochromique et sur la base d'un ratio de distribution de capacité défini pour obtenir une capacité correspondant à chaque niveau ; et charger et décharger le dispositif électrochromique, surveiller les capacités actuelles du dispositif électrochromique et, en réponse aux capacités actuelles surveillées étant séparément égales à des capacités distribuées, enregistrer des tensions en circuit ouvert correspondantes pour obtenir une relation correspondante initiale parmi chaque niveau du dispositif électrochromique, une tension en circuit ouvert du dispositif électrochromique et la capacité du dispositif électrochromique.

15. Dispositif électrochromique, dans lequel le dispositif électrochromique comprend un processeur et une mémoire, dans lequel la mémoire stocke un programme informatique et le processeur est configuré pour exécuter le programme informatique pour mettre en œuvre le procédé selon l'une quelconque des revendications 1 à 9.

16. Support de stockage lisible par ordinateur stockant un programme informatique qui, lorsqu'il est exécuté par un processeur d'un dispositif électrochromique, met en œuvre le procédé selon l'une quelconque des revendications 1 à 9.
